# EUROPEAN PATENT SPECIFICATION

(11) **EP 1 487 110 B1**
(45) Date of publication and mention of the grant of the patent: **22.11.2006**
(21) Application number: 04006398.4
(22) Date of filing: 17.03.2004
(51) Int. Cl.: H03M 1/06

(54) **D/A converting device with offset compensation function and offset compensation method for D/A converting device**
D/A-Wandler mit Versatzkompensationsfunktion und Verfahren zur Kompensation des Versatzes in einem D/A-Wandler
Appareil de conversion N/A à fonction de compensation de décalage et procédé de compensation de décalage d'un appareil de conversion N/A.

(30) Priority: 10.06.2003 JP 2003165307
(43) Date of publication of application: 15.12.2004
(73) Proprietor: MATSUSHITA ELECTRIC INDUSTRIAL CO., LTD., Kadoma-shi, Osaka 571-8501 (JP)
(72) Inventor: Itoh, Minoru, Shiga-gun, Shiga 520-0532 (JP)
(74) Representative: Grünecker, Kinkeldey, Stockmair & Schwanhäusser Anwaltssozietät

(56) References cited:
- US-A- 5 894 280
- US-A- 6 100 827
- US-A1- 2002 039 075
- US-B1- 6 278 391

## Description

### Background of the Invention

### Field of the Invention

The present invention relates to a D/A converting device with an offset compensation function, which compensates DC offset of a D/A converter.

### Description of the Related Art

In the digital radio communication equipment, respective I(In-phase), Q(Quadrature) signals, which are subjected to the digital modulation, are D/A-converted, then coupled in the radio frequency portion of the radiotelephony, and then sent out from the antenna as the radio signal. Ideally, analog output voltage of the D/A converter should coincide with ideal analog output voltage (analog output voltage without DC offset) that corresponds to digital input value. Actually, the DC offset is generated between the actual analog output voltage and the ideal analog output voltage because of various factors.

In the case of the differential output type D/A converter, if the DC offset is generated between differential outputs (I+ and I-, or Q+ and Q-) of the D/A converter, which correspond to the I signal and the Q signal respectively, (i.e., input/output characteristics of differential outputs of the D/A converter is different), a phase between respective I, Q signals is shifted to generate a transmission error. Therefore, the characteristics of the D/A converters must be made uniform by canceling the DC offset between the differential outputs of the D/A converter.

In order to cancel the DC offset between the differential outputs of the D/A converter, the DC offset between the differential outputs of the D/A converter in response to test data must be measured in a test mode where no input signal is present. For this purpose, a comparator (a voltage comparator) is employed.

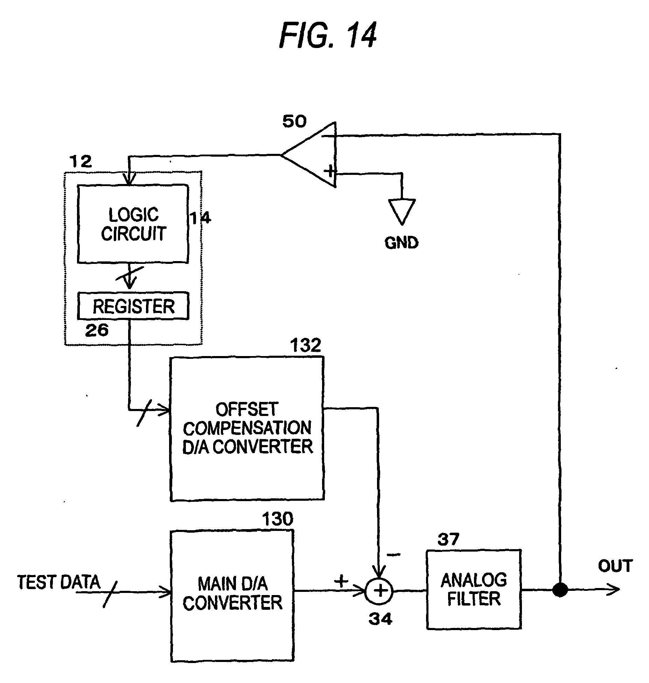

FIG.14 shows a related art applied to compensate the offset. In the related art, the compensation value is derived by calculating the signal, which is obtained based on the result of voltage comparison by the comparator 50, in a logic circuit 14 by using the binary search method. Then, this compensation value is stored in a register 26.

Then, the analog output signal obtained based on the compensation value stored in the register 26 via an offset compensation D/A converter 132 is subtracted from an analog output voltage of a main D/A converter 130. Then, the resultant signal is returned to the comparator 50. The compensation value (control data) used to compensate the DC offset between the output voltage of the D/A converter 130 and GND is calculated by repeating above procedures.

There is the technology to cancel the DC offset between the output voltage of the D/A converter 130 and GND by subtracting an analog output voltage derived based on a compensation value, which is obtained by subtracting (1/2) LSB from the above compensation value, via the offset compensation D/A converter 132 from the analog output voltage of the main D/A converter 130 (for example, see U.S. Patent No.6313769).

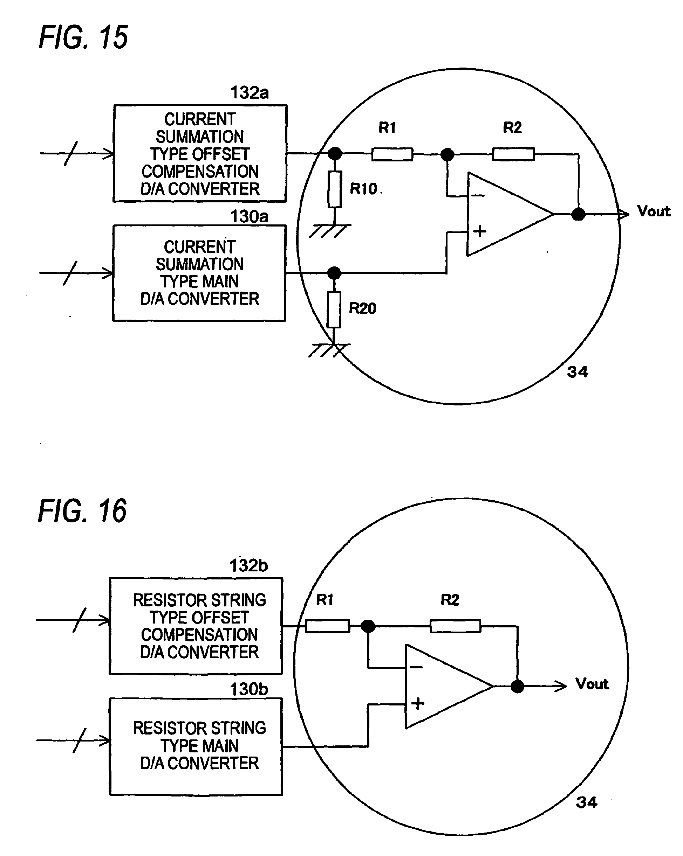

Also, a method of synthesizing the analog output voltage of the main D/A converter 130 and the analog output voltage obtained via the offset compensation D/A converter 132 is shown in FIG.15 and FIG.16. FIG.15 shows a case of the current summation type D/A converters 130a, 132a. FIG.16 shows a case of the resistor string type D/A converters 130b, 132b.

U.S. Patent No.6313769 Specification (FIG.1, FIG.4, etc.) is known as a related art.

However, the DC offset actually exists in a comparator that detects the DC offset in the D/A converter in a single output type D/A converting device and in a comparator that detects the DC offset between the differential outputs of the D/A converter in a differential output type D/A converting device. Normally, the DC offset of the comparator is designed to be suppressed within several mV.

However, according to the study of the inventor of the present invention, it was confirmed that in some cases the DC offset of the comparator itself is in excess of 20 mV due to variation in transistor size, LSI production processing conditions, etc. In particular, the DC offset of the comparator tends to increase as the transistor size is miniaturized.

The DC offset contained in the comparator causes an error in measuring the DC offset (containing the DC offset between the differential outputs) of the D/A converter. As a result, the precise measurement cannot be carried out if the DC offset of the comparator itself is large, and thus the DC offset of the D/A converter cannot be perfectly removed.

Document US 5 894 280 discloses a digital synthesiser with a offset compensation function. This prior art has two primary phases of operation. In a calibration phase, it determines the offset of the D/A converter by means of a comparator and an autocalibration control circuit, and in a normal operation phase, the determined offset of the D/A converter is added/subtracted to the input signal of the D/A converter. In the calibration phase, the inputs of the comparator are connected to the outputs of the DIA converter via a switch which is controlled by the autocalibration control circuit. This switch allows for a swap of the outputs of the D/A converter coupled to the inputs of the comparator. Also in the calibration phase, the initial digital value of the input of the D/A converter is zero. After configuring the switch, the autocalibration control circuit subsequently increments this value until the state of the comparator transitions. When the comparator transitions, the offset of the digital synthesiser equals the calibration value, and the autocalibration control circuit records the calibration value as a transition code. In order to cancel the offset of the comparator, this prior art determines two compensation values, a "positive" transition code determined when the polarity of the output of the D/A converter matches the polarity of the input of the comparator, a "negative" transition code when the polarity of the output of the DAC is inverted compared to the polarity of the input of the comparator, and averages these values for obtaining the offset of the D/A converter.

Document US 2002/0039075 describes a D/A converter circuit which makes the offset-correction at the output side. This prior art includes a correction value setting section for generating a digital correction value to cancel the offset, a second D/A converter to convert the digital correction value into an analog voltage, and an analog adder to add together the output voltage of the D/A converter and the analog voltage corresponding to the digital correction value.

Document US 6 100 827 discloses an D/A converter which reduces the DC offset within acceptable limits for the modulation by subtracting from the digital input signal, a digital value representing the DC offset of the output signal of the D/A converter. A sensor senses the DC offset of the analog signal output by the D/A converter. An A/D converter is responsive to the sensor to convert the sensed DC offset into a digital offset signal. A subtractor is responsive to the A/D converter to subtract the digital DC offset signal from the digital input signal and to apply the resulting signal to the D/A converter. In order to remove any DC error of the A/D converter, one embodiment of this prior art also includes a polarity inverter that periodically inverts the polarity of the sensed DC offset signal.

### Summary of the Invention

The object of the present invention is to provide a D/A converting device with an offset compensation function which enable to remove a DC offset of the D/A converter even though a DC offset exists in a comparator.

This is achieved by a D/A converting device with an offset compensation function for compensating a DC offset of a D/A converter, having a comparator for detecting the DC offset of the D/A converter; a changing switch for selecting the inputs to the comparator based on a mode switching signal, wherein in a first input mode first and second signals are input into first and second input terminals of the comparator respectively, in a second input mode the second and first signals are input into the first and second input terminals of the comparator respectively, and at least one of the first and second signals is an output signal of the D/A converter; and offset compensating means for calculating a third compensation value from a first compensation value which is obtained based on an output signal of the comparator in the first input mode and a second compensation value which is obtained based on an output signal of the comparator in the second input mode; and an offset compensation D/A converter for correcting the output signal of the D/A converter based on the third compensation value wherein
said offset compensating means (10) determines the first and second compensation values by using the successive approximation method based on a binary search, and
said offset compensating means (10) adds 1/2 to the first and second compensation values when least significant bits of the first and second compensation values are 0, and subtract 1/2 from the first and second compensation values when the least significant bits of the first and second compensation values are 1.

An offset compensation method of a D/A converting device which detects a DC offset of a D/A converter by using a comparator to compensate the DC offset of the D/A converter, having the steps of: obtaining a first compensation value based on an output signal of the comparator in a first input mode in which first and second signals, wherein at least one of these signals is an output signal of the D/A converter, are input into first and second input terminals of the comparator respectively; obtaining a second compensation value based on an output signal of the comparator in a second input mode in which second and first signals are input into the first and second input terminals of the comparator respectively; calculating a third compensation value from the first compensation value and the second compensation value; and correcting an analog output of the D/A converter by an analog output that corresponds to the third compensation value.

According to the above configuration, information of the voltage that is equal in magnitude but opposite in polarity to the DC offset contained in the comparator itself are generated indirectly by executing the switching of the inputs into the comparator, and then the DC offset of the comparator itself is canceled when the DC offset of the D/A converter is to be measured, which makes possible exact measurement of the DC offset of the D/A converter.

More particularly, if the switching of the signals being input into the comparator is executed, for example, the DC offset of the comparator itself acts to enlarge a difference between two signals being input into the comparator in the first compensation value measured before the switching, while such DC offset of the comparator itself acts to contract a difference between two signals in the second compensation value measured after the switching. In other words, the polarity of the DC offset contained in the comparator is inverted before and after the switching. In contrast, the DC offset of the D/A converter is identical (the polarity is also identical) irrespective of the switching of the inputs into the comparator.

Therefore, if the first and second compensation values that are generated based on respective signals measured before and after the inputs into the comparator are switched are added, the DC offset component contained in the comparator is canceled substantially, while the DC offset of the D/A converter is doubled simply. As a result, the compensation value applied to the net offset of the D/A converter, from which the DC offset of the comparator is removed, can be calculated exactly by dividing the DC offset component of the D/A converter by 2 (by taking an average).
Also, the D/A converting device and the offset compensation method can be applied to either the case where the A/D converter is of differential output type (complementary output type to expand a dynamic range of the converted outputs) or the case where the A/D converter is of single output type.

### Brief Description of the Drawings

FIG.1 is a view explaining a configuration and an operation (operation of generating a first compensation value) of an example of a D/A converting device with an offset compensation function (a D/A converter has a differential output configuration);
FIG. 2 is a view explaining an operation (operation of generating a second compensation value) of the example of the D/A converting device with the offset compensation function;
FIG. 3 is a view explaining an operation (operation of generating a third compensation value) of the example of the D/A converting device with the offset compensation function;
FIG.4 is a view explaining a normal operation (operation of executing a D/A conversion while compensating a DC offset of the D/A converter by using the third compensation value) in the D/A converting device with the offset compensation function;
FIG.5A and FIG. 5B are views showing a DC offset compensation value when no DC offset exists in a comparator in FIG.4;
FIG.5C and FIG.5D are views showing a DC offset compensation value when a DC offset exists in the comparator before inputs are switched (at the time of non-crossing inputs);
FIG.5E and FIG.5F are views showing a DC offset compensation value when the DC offset exists in the comparator after inputs are switched (at the time of crossing inputs);
FIG.5G is a view showing the event that a DC offset compensation value serving as a basis of the third compensation value is identical to the DC offset compensation value measured by the comparator that has no DC offset (case (a));
FIG.6 is a view explaining the reason why the DC offset can be canceled in the D/A converter with the offset compensation function;
FIG.7 is a block diagram showing the D/A converter with the offset compensation function of the first embodiment, a part of the configuration of which is varied without change of the function;
FIG.8 is another block diagram showing the D/A converting device with the offset compensation function in the first embodiment, a function of which is not changed but a part of a configuration of which is varied;
FIG.9 is a view explaining a schematic configuration of an example of a D/A converting device with an offset compensation function employing a binary search method of the present invention;
FIG.10 is a view explaining an operation of the D/A converting device with the offset compensation function employing the binary search method of the present invention;
FIG.11 is a view explaining a configuration of another example (a D/A converter has a single output configuration) of the D/A converter with the offset compensation function;
FIG.12A is a view showing a DC offset compensation value when no DC offset exists in a comparator in FIG.11;
FIG.12B is a view showing a DC offset compensation value when a DC offset exists in the comparator before inputs are switched (at the time of non-crossing inputs);
FIG.12C is a view showing a DC offset compensation value when the DC offset exists in the comparator after inputs are switched (at the time of crossing inputs);
FIG.12D is a view showing the event that a DC offset compensation value serving as a basis of a mean compensation value is identical to the DC offset compensation value measured by the comparator that has no DC offset (case (a));
FIG.13 is a block diagram showing a configuration of a digital radio transmitter into which the D/A converter with the offset compensation function (packaged as LSI) of the present invention is installed;
FIG.14 is a block diagram showing the related art of compensating the offset;
FIG.15 is a view showing a method of synthesizing the analog output voltage in the current summation type D/A converter; and
FIG.16 is a view showing a method of synthesizing the analog output voltage in the resistor string type D/A converter.

### Detailed Description of the Preferred Embodiments

Embodiments will be explained with reference to the drawings hereinafter. But explanations given in the following should not be interpreted to limit the scope of the present invention.

### (First Embodiment)

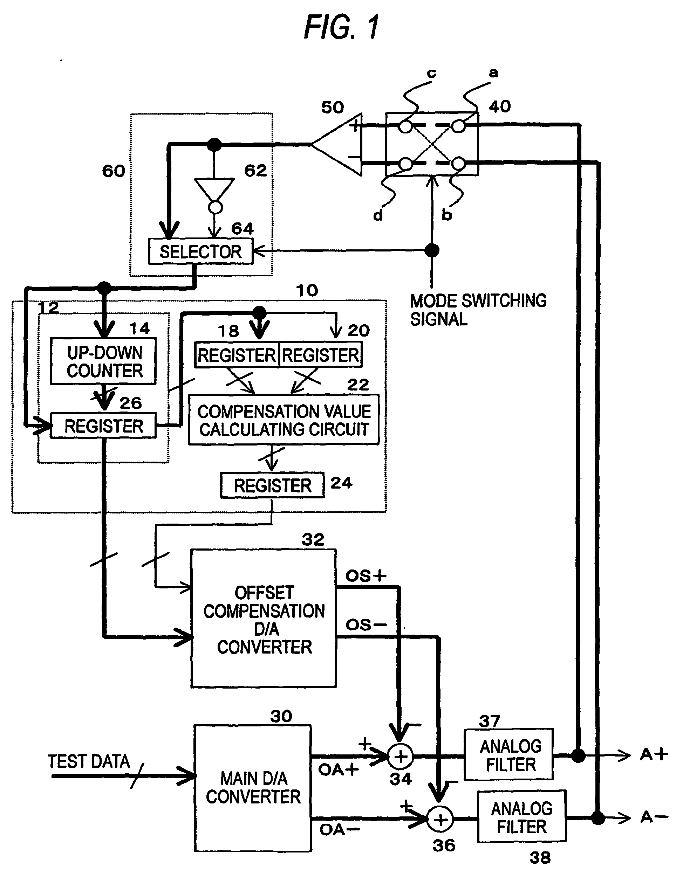

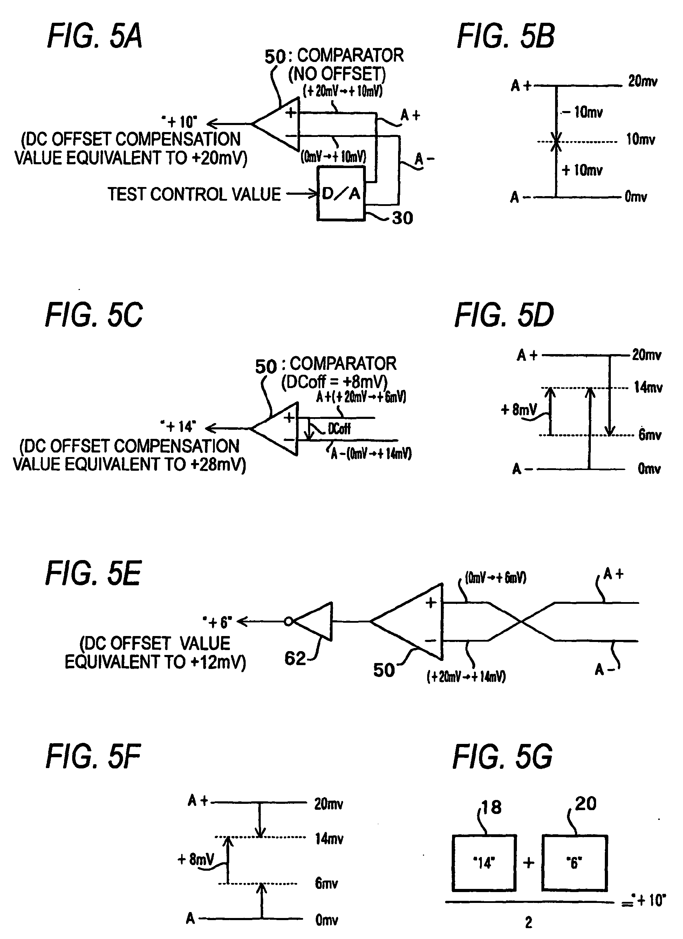

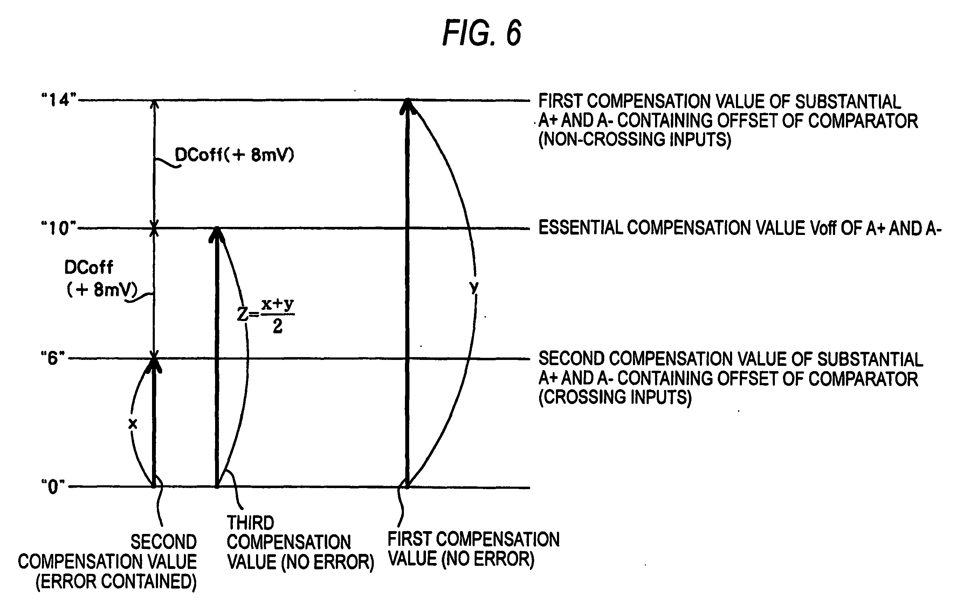

FIG. 1 to FIG.4 are block diagrams explaining a schematic configuration and an operation of a D/A converting device with an offset compensation function in the first embodiment. FIG.5 and FIG.6 are views explaining behaviors in which the DC offset of the comparator itself is canceled.

A schematic configuration of the D/A converting device with the offset compensation function will be explained with reference to FIG.1 hereunder. As shown in FIG.1, the D/A converting device of the first embodiment includes an offset compensation value generating portion 10, a main D/A converter 30 having a differential output configuration, an offset compensation D/A converter 32 having a differential output configuration, signal synthesizing portion 34 and 36 for subtracting two pairs of differential output voltages of the offset compensation D/A converter 32 from two pairs of differential output voltages of the D/A converter 30, analog (low-pass) filters 37 and 38, a comparator 50, an input changing switch 40 provided at the preceding stage of the comparator 50, and an polarity inverting circuit 60 (having an inverter 62 and a selector 64) for inverting selectively the polarity of an output signal of the comparator 50. The analog filters 37, 38 positioned after the signal synthesizing portions 34, 36 may be provided arbitrarily.

The offset compensation value generating portion 10 includes a compensation value generating means 12 (consisting substantially of an up-down counter 14 and a register 26) using the successive approximation method that changes the reference value 1 LSB by 1 LSB, two registers 18, 20 for storing temporarily a first compensation value and a second compensation value respectively, a compensation value calculating circuit 22, and a register 24 for storing the result of the compensation value calculation.

In this D/A converting device with the offset compensation function, in view of the event that the comparator 50 itself contains the DC offset, a total DC offset containing the DC offsets between the differential outputs of the D/A converters 30 and 32 and the DC offset of the comparator 50 itself is compensated by the negative feedback control.

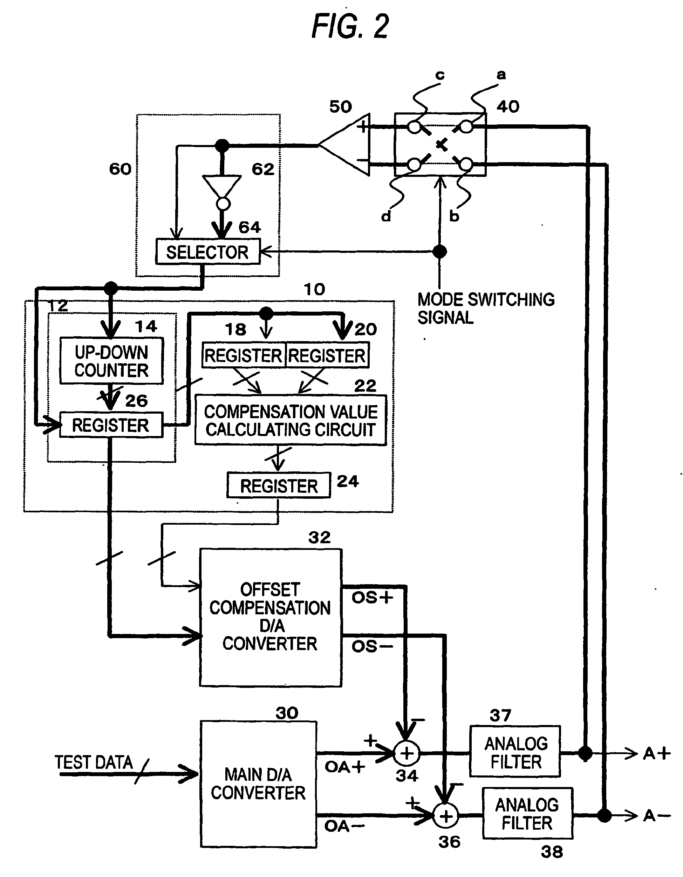

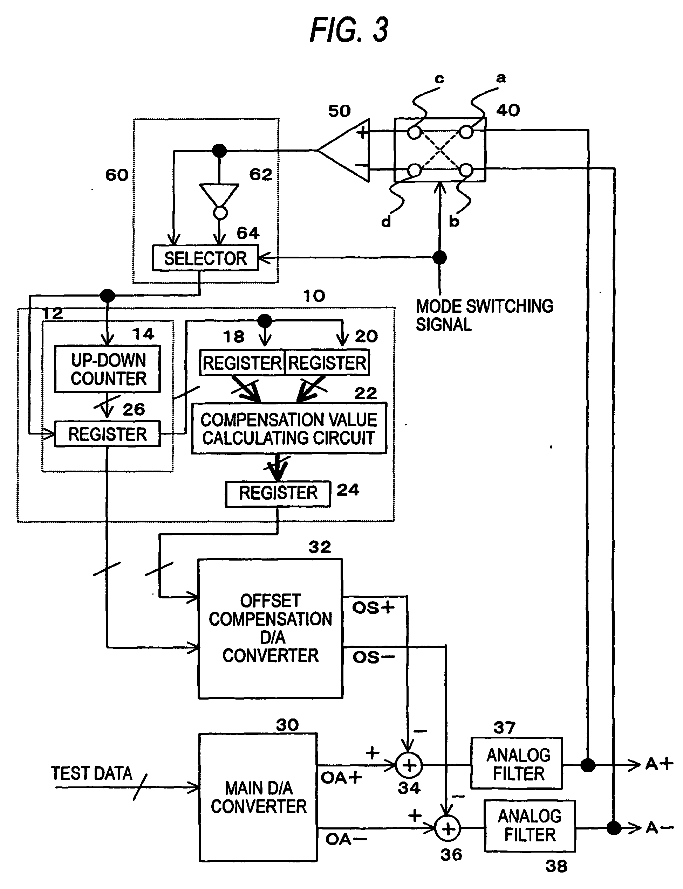

Next, an operation of compensating the DC offset will be explained hereunder. In a test mode that no signal to be transmitted to the radio path is present, this operation is roughly classified into a phase at which a first compensation value is calculated (FIG.1), a phase at which a second compensation value is calculated (FIG.2), and a phase at which a third compensation value is calculated (FIG.3).

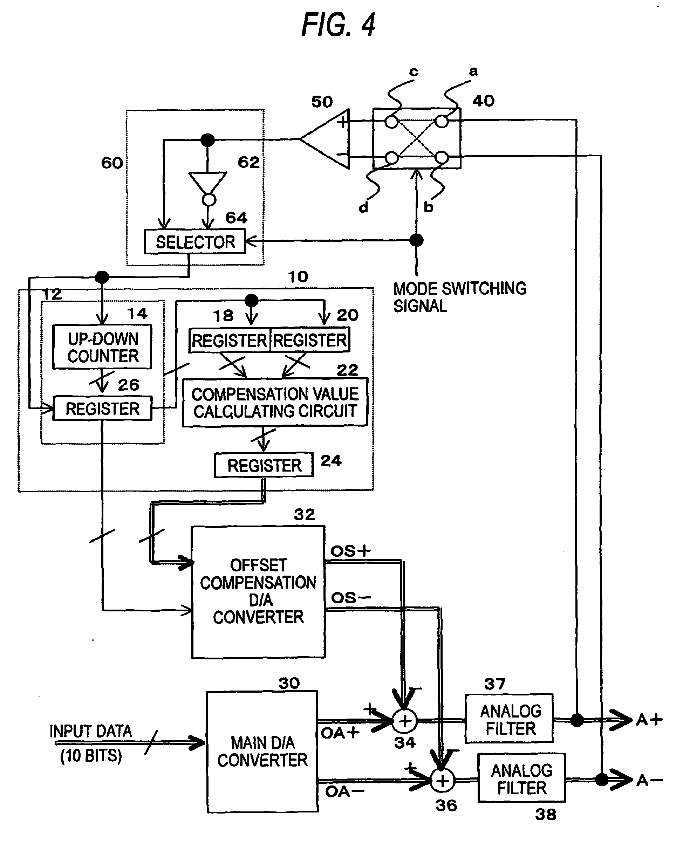

As shown in FIG.4, the normal input data are input into the D/A converter 30, and then the differential output voltages obtained based on the third compensation value stored in the register 24 via the offset compensation D/A converter 32 are subtracted from the differential output voltages of the D/A converter 30 by the signal synthesizing portions 34 and 36. Thus, the DC offset between the differential outputs of the D/A converter 30 can be removed. In this case, except that the DC offset between the differential outputs of the D/A converter 30 is corrected in terms of voltage via the offset compensation D/A converter 32, such DC offset can be corrected in terms of current.

Then, explanation will be made concretely hereunder. In FIG.1, operations (procedures) of calculating the first compensation value in the test mode are indicated by thick lines. First, the test data (for example, digital input data corresponding to an analog output 0 V (an almost intermediate value of VDD and VSS) of the D/A converter 30) are given to the D/A converter 30.

Complementary outputs whose phases are mutually inverted are obtained from the D/A converter 30. These two output signals are expressed as "OA+", "OA-" respectively. Assume that OA+ is a non-inverting output with respect to the digital input data, and OA- is an inverted output with respect to the digital input data.

The first count value of the compensation value generating means 12 is zero. Therefore, differential output voltages "OS+", "OS-" of the offset compensation D/A converter 32 in response to the compensation value 0 are subtracted from the differential output voltages of the D/A converter 30 by the signal synthesizing portions 34 and 36 respectively. Thus, "A+" and "A-" are obtained. Assume that A+ is a non-inverting output with respect to the compensation value, and A- is an inverting output with respect to the compensation value. Respective signals A+, A- are input into the comparator 50 via the changing switch 40.

As shown in FIG.1, the changing switch 40 has a function of connecting selectively input terminals "a", " b" to any of output terminals "c", "d". In the changing switch 40 in FIG.1, the terminal "a" and the terminal "c" are connected mutually, and the terminal "b" and the terminal "d" are connected mutually. Assume that this state is the first input mode. In this first input mode, the selector 64 in the polarity inverting circuit 60 passes the output signal of the comparator 50 through as it is.

The output signal of the comparator 50 is given to the up-down counter 14 and the register 26, which functions as the compensation value generating means 12.

The up-down counter 14 executes the up-counting operation when the output signal of the comparator 50 given at this time is at +1 (high level), and executes the down-counting operation when the output signal is at -1 (low level). This count value is stored in the register 26.

On the other hand, the differential output voltages "OS+", "OS-" of the offset compensation D/A converter 32 in answer to the value (count value) of the register 26 are subtracted from the differential output voltages of the D/A converter 30 by the signal synthesizing portions 34 and 36 respectively. Thus, "A+" and "A-" are derived.

Similar operations are executed by repeating the above operations in the following, and are continued until the polarity of the output signal of the comparator 50 is inverted. In other words, the compensation value generating means 12, when detects the inversion of the polarity of the output signal of the comparator 50, causes the register 18 to hold the count value at this time (this is the first compensation value) therein. In this case, the detection of the polarity inversion must be carried out prudently while taking account of the infinitesimal fluctuation of the signal voltage.

Next, as shown in FIG.2, the changing switch 40 is controlled to connect the terminal "a" to the terminal "d" and connect the terminal "b" to the terminal "c". Assume that this state is a second input mode. At this time, the selector 64 in the polarity inverting circuit 60 selects the output signal of the inverter 62. That is, the inverted signal of the output signal of the comparator 50 is given to the up-down counter 14 and the register 26.

In such state, the count value of the compensation value generating means 12 is restored to zero, and then similar operations to those in FIG.1 are carried out, otherwise an operation of calculating the second compensation value continuously from the same count value as the first compensation value being calculated by the operation in FIG. 1. The resultant second compensation value is stored in the register 20.

Then, as shown in FIG.3, the first and second compensation values are picked up from the register 18 and the register 20 respectively, then the third compensation value is calculated by executing an average operation by the compensation value calculating circuit 22, and then the third compensation value is stored in the register 24.

This third compensation value indicates the compensation value obtained when the comparator 50 does not have the DC offset at all (i.e., the compensation value that is generated based on the measured result obtained by measuring exactly the DC offset between the differential outputs of the D/A converter 30, and is able to cancel the DC offset perfectly).

Therefore, as shown in FIG.4, the differential output voltages obtained based on the calculated third compensation value via the offset compensation D/A converter 32 are subtracted from the differential output voltages of the D/A converter 30, into which the normal input data are input, by the signal synthesizing portions 34 and 36 respectively. Thus, the DC offset between the differential outputs of the D/A converter 30 can be removed perfectly.

The reason why the offset of the comparator 50 is masked perfectly by the above method and disappears will be explained concretely with reference to FIGs.5A to 5G and FIG.6 hereunder. Here, assume that the minimum resolution (LSB) of the D/A converter 30 is set to 1 mV.

In FIG.5A, the case where the comparator 50 does not have the DC offset at all is assumed. When the test data (testing control value: data that are equivalent to 0 V) are given to the D/A converter 30, the DC offset appears as the DC offset between the differential outputs if the D/A converter 30 has such DC offset, for the differential outputs A+, A- of the D/A converter 30 are independently provided mutually. Here, assume that a voltage of A+ out of the complementary outputs of the D/A converter 30 is 20 mV and a voltage of A- is 0 mV. In essence, two outputs ought to become 0 mV together. Consequently, the DC offset of 20 mV is generated between the differential outputs in this case.

Next, what compensation value is required (what level the compensation value should be set) to cancel the DC offset of 20 mV will be examined hereunder. Here, what is to be noted is such an aspect that, in the case of the differential output type D/A converter 30, A+ is corrected by -1 mV in response to the compensation value "+1" and conversely A- is corrected by 1 mV in response to the same value. That is, in the case of the differential output type D/A converters 30, 32, a correction of -2 mV is applied in total between A+, A- in response to the compensation value "+1".

As described above, now the DC offset between the differential outputs of 20 mV is present between A+, A-. Therefore, in order to cancel this DC offset, as shown in FIG.5B, a correction to subtract 10 mV from A+ (20 mV) and add 10 mV to A- (0 mV) may be applied (i.e., a 10 mV correction may be applied to A+, A- respectively). As a result, the necessary compensation value becomes "+10".

Here, as shown in FIG.5C, the comparator 50 has the DC offset (Here, the DC offset is supposed such that substantially a voltage of the inverting terminal is 8 mV higher than a voltage of the non-inverting terminal). In this case, the DC offset 8 mV of the comparator 50 is added to the essential DC offset 20 mV between the differential outputs of the D/A converter 30, and thus the DC offset is expanded to 28 mV.

In order to cancel the DC offset 28 mV, as shown in FIG.5D, a correction to subtract 14 mV from A+(20 mV) and add 14 mV to A-(0 mV) may be applied. As a result, the necessary compensation value (first compensation value) becomes "+14".

Then, as shown in FIG.5E, the input into the comparator 50 is switched. Then, A+ (this is set to +20 mV by the influence of the DC offset of the D/A converter 30) is input into the inverting terminal of the comparator 50. Also, A- (0 mV) is input into the non-inverting terminal of the comparator 50.

As a consequence, the DC offset 8 mV of the comparator 50 is subtracted from the essential DC offset 20 mV between the differential outputs of the D/A converter 30 to give 12 mV, and the error is reduced. However, since actually -12 mV(= -20 mV + 8 mV) is applied as the input of the comparator 50, the polarity of the output of the comparator 50 becomes minus. Therefore, the polarity is inverted by the inverter 62 and the compensation value is calculated.

In order to cancel this DC offset 12 mV, as shown in FIG.5F, a correction to subtract 6 mV from A+ (20 mV) and add 6 mV to A- (0 mV) may be executed. As a result, the compensation value (second compensation value) becomes "+6".

Then, as shown in FIG.5G, the third compensation value (="+10") is derived by taking an average of the first compensation value and the second compensation value. This value of the third compensation value coincides with the compensation value (="+10") obtained in FIG.5A when the comparator 50 does not have the DC offset at all. That is, the DC offset of the comparator 50 itself is masked and disappears. Therefore, the DC offset between the differential outputs of the D/A converter 30 is precisely measured, and thus the exact compensation value is derived based on this DC offset.

In other words, the compensation value of the DC offset between the differential outputs of the D/A converter 30 is "+10". Such a mode is employed that the compensation value (="+4") of the DC offset of the comparator 50 itself is added to this essential DC offset before the inputs into the comparator 50 are switched, while such a mode is employed that the compensation value (="+4") of the DC offset of the comparator 50 itself is subtracted after the inputs are switched. That is, the polarity of the DC offset of the comparator 50 itself is inverted before and after the inputs are switched.

On the contrary, the polarity of the essential DC offset (=+20 mV) between the differential outputs of the D/A converter 30 is identical before and after the inputs are switched. That is to say, the polarity of the output value is inverted after the inputs are switched but such inverted polarity is inverted by the inverter 62, so that the measured DC offset compensation value between the differential outputs still remains at "+10".

Accordingly, the first compensation value (compensation value 1) and the second compensation value (compensation value 2) are added, so the DC offset component of the comparator 50 is canceled whereas the essential DC offset component between the differential outputs of the D/A converter 30 is twice increased. Therefore, the compensation value corresponding only to the essential DC offset component between the differential outputs of the D/A converter 30 can be obtained by dividing such added DC offset component by 2.

A view showing the principle of the DC offset canceling comprehensively is FIG.6. Assume that the compensation value of the essential DC offset between the differential outputs A+ and A- of the D/A converter 30 is Voff, this Voff is "+10 (equivalent to +20 mV)", as described above.

Such a mode is taken that the DC offset DCoff (=+8 mV) of the comparator 50 is added before the inputs of the comparator 50 are switched (at the time of non-crossing inputs). Assume that the first compensation value (compensation value 1) is "y", the "y" becomes "+14".

In contrast, such a mode is taken that the DC offset DCoff (=+8 mV) of the comparator 50 is subtracted after the inputs of the comparator 50 are switched (at the time of crossing inputs). Assume that the second compensation value is "x", the "x" becomes "+6". Now, x + y = 2Voff. Therefore, (x+y)/2 = Voff = z is derived. This third compensation value "z" gives the compensation value that corresponds to the essential DC offset between the differential outputs.

In the first embodiment, when connections between the inverting terminal, the non-inverting terminal of the comparator 50 and the terminals "c", "d" of the input changing switch 40 are reversed, the output of the comparator 50 is reversed completely in contrast to the first embodiment, and thus the operation of the up-down counter 14 is also reversed in contrast to the first embodiment. Therefore, the polarity of the resultant compensation value here is inverted.

Therefore, the outputs of the main D/A converter 30 must be corrected by subtracting OS- and OS+ of the offset compensation D/A converter 32 from OA+ and OA- of the main D/A converter 30, into which the test data are input, respectively.

Similarly, the first, second, and third compensation values are equal in magnitude but opposite in polarity to respective compensation values in the first embodiment. Therefore, outputs of the main D/A converter 30 are corrected by subtracting OS- and OS+ of the offset compensation D/A converter 32 from OA+ and OA- of the main D/A converter 30, into which the test data are input, respectively, so the DC offset between the differential outputs of the D/A converter 30 can be removed perfectly.

In the first embodiment, in the case where the first compensation value is calculated based on the inverted signal of the output signal of the comparator 50 in the first input mode and also the second compensation value is calculated based on the output signal of the comparator 50 in the second input mode, similarly compensation values in respective input modes, i.e., the first compensation value, the second compensation value, and the third compensation value are equal in magnitude but opposite in polarity to respective compensation values in the first embodiment.

As a consequence, in this case, if the outputs of the main D/A converter 30 are corrected by subtracting OS- and OS+ of the offset compensation D/A converter 32 from OA+ and OA- of the main D/A converter 30 respectively, the DC offset between the differential outputs of the D/A converter 30 can also be removed perfectly, like the first embodiment.

### (Second Embodiment)

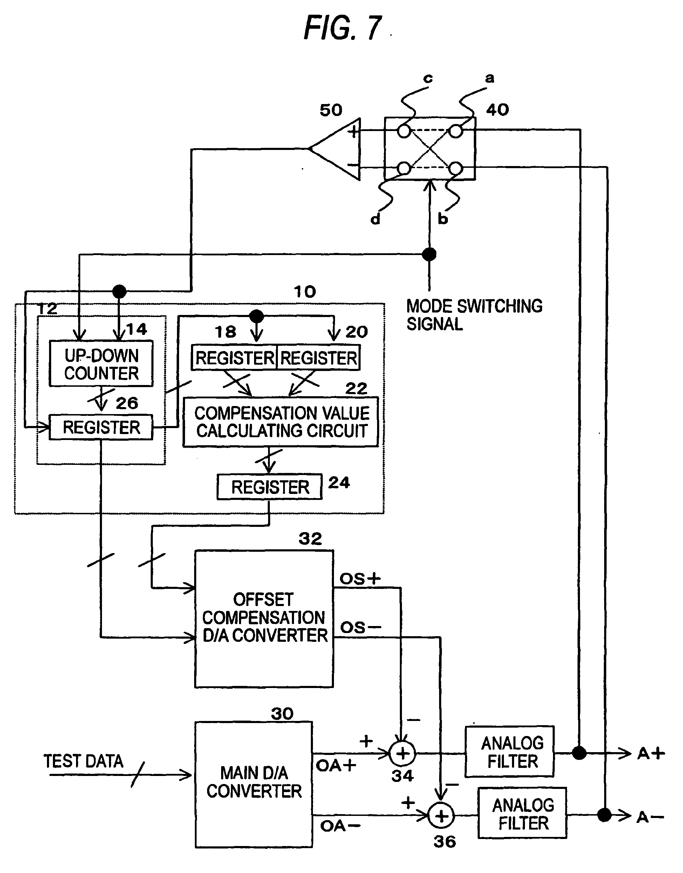

FIG.7 is a block diagram showing the D/A converting device with the offset compensation function in the first embodiment shown in FIG.1 to FIG.4, the function of which is not changed but a part of the configuration of which is varied.

In the second embodiment, instead of removal of the polarity inverting circuit 60 (including the inverter 62 and the selector 64) to selectively invert the polarity of the comparator 50, the counting operation of the up-down counter 14 may be reversed by the mode switching signal in the first input mode and the second input mode respectively.

More particularly, in the first input mode, the up-down counter 14 executes the up-counting operation when the output of the comparator is at +1 (high level) and executes the down-counting operation when the output of the comparator is at -1 (low level). Conversely, in second input mode, the up-down counter 14 executes the down-counting operation when the output of the comparator is at +1 (high level) and executes the up-counting operation when the output of the comparator is at -1 (low level).

Since the outputs of the up-down counter 14 are identical to those in the first embodiment in both modes after this variation is applied, the function and the operation of the D/A converting device with the offset compensation function do not change at all.

### (Third Embodiment)

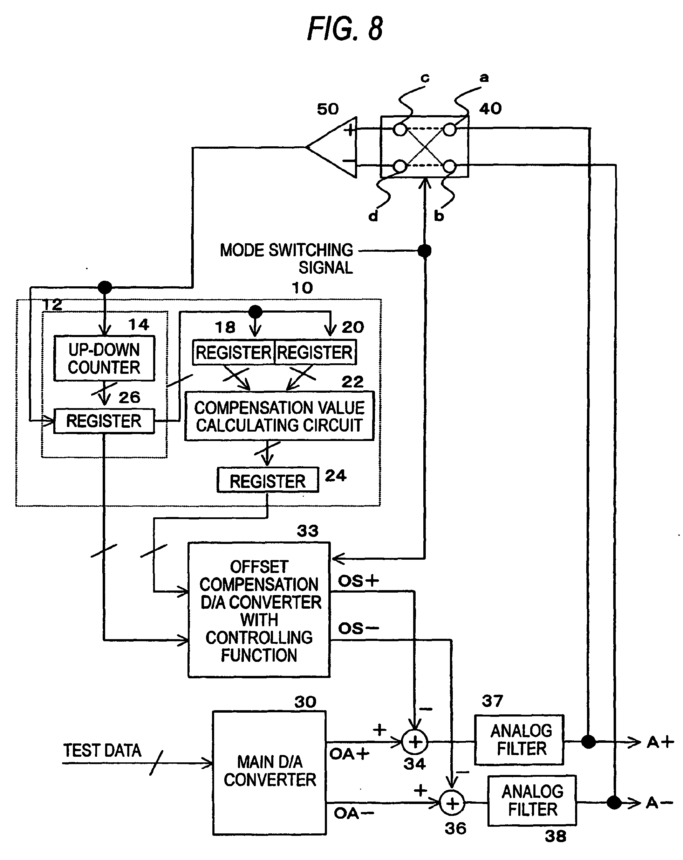

FIG.8 is another block diagram showing the D/A converting device with the offset compensation function in the first embodiment shown in FIG.1 to FIG.4, a function of which is not changed but a part of a configuration of which is varied.

In the third embodiment, the polarity inverting circuit 60 (having the inverter 62 and the selector 64) for inverting selectively the polarity of the output signal of the comparator 50 is removed, and alternately the offset compensation D/A converter 32 is replaced with an offset compensation D/A converter 33 with a controlling function. Then, in an operation of the offset compensation D/A converter 33 with the controlling function for generating the offset compensation analog output based on the compensation value, in the first input mode, OS+ is generated as the signal being input into the signal synthesizing portion 34 by the mode switching signal and also OS- is generated as the signal being input into the signal synthesizing portion 36.

In the second input mode, conversely OS- is generated as the signal being input into the signal synthesizing portion 34 by the mode switching signal and also OS+ is generated as the signal being input into the signal synthesizing portion 36.

According to this modification, the second compensation value calculated in the second input mode is equal in magnitude but opposite in polarity to the second compensation value in the first embodiment. Therefore, if the third compensation value is calculated by subtracting the second compensation value from the first compensation value and then dividing the resultant value by 2 and in addition the differential outputs OS+ and OS- obtained based on the resultant third compensation value via the offset compensation D/A converter 33 are subtracted from the differential outputs OA+ and OA- of the D/A converter 30, into which the normal input data are input, by the signal synthesizing portions 34 and 36 respectively, the DC offset between the differential outputs of the D/A converter 30 can be removed perfectly.

Similarly, if the third compensation value is calculated by subtracting the first compensation value from the second compensation value and then dividing the resultant value by 2 and in addition the differential outputs OS- and OS+ obtained based on the resultant third compensation value via the offset compensation D/A converter 33 are subtracted from the differential outputs OA+ and OA- of the D/A converter 30, into which the normal input data are input, by the signal synthesizing portions 34 and 36 respectively, the DC offset between the differential outputs of the D/A converter 30 can be removed perfectly.

In the third embodiment, when connection between the input terminal of the comparator 50 and the changing switch 40 is reversed or when the inverted signal of the output signal of the comparator 50 is input into the compensation value generating means 12, the operation of the offset compensation D/A converter 33 with the controlling function is reversed from that of the third embodiment, and also the first compensation value, the second compensation value, and the third compensation value are equal in magnitude but opposite in polarity to those in the third embodiment.

### (Fourth Embodiment)

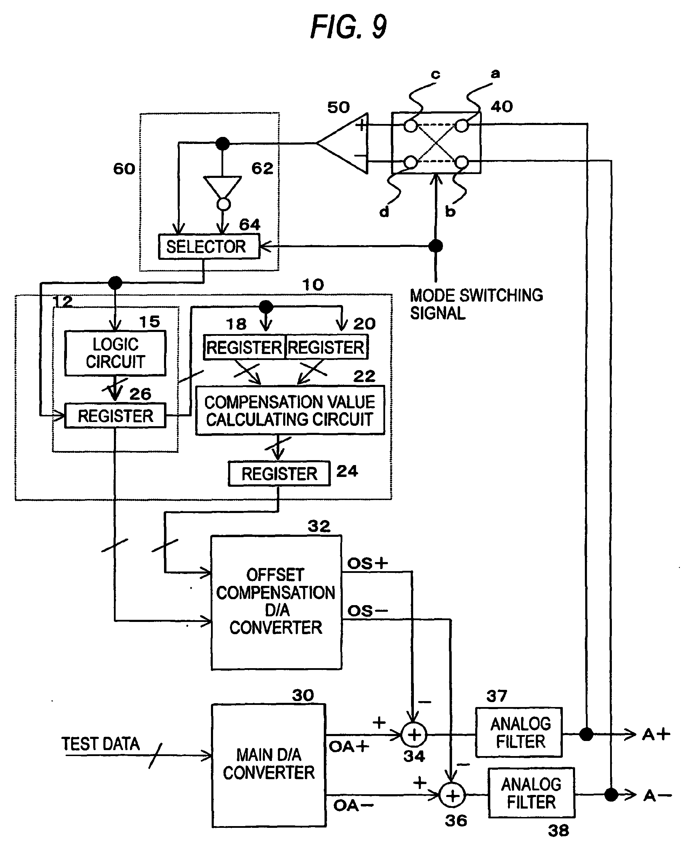

FIG.9 is a block diagram showing a D/A converting device with an offset compensation function, which uses a binary search method to calculate the first and second compensation values in the first and second input modes in the first embodiment shown in FIG.1 to FIG.4.

In the fourth embodiment, the binary search method is employed in place of the successive approximation method that changes the reference value 1 LSB by 1 LSB by the up-down counter that is employed in the first embodiment shown in FIG.1 to FIG.4.

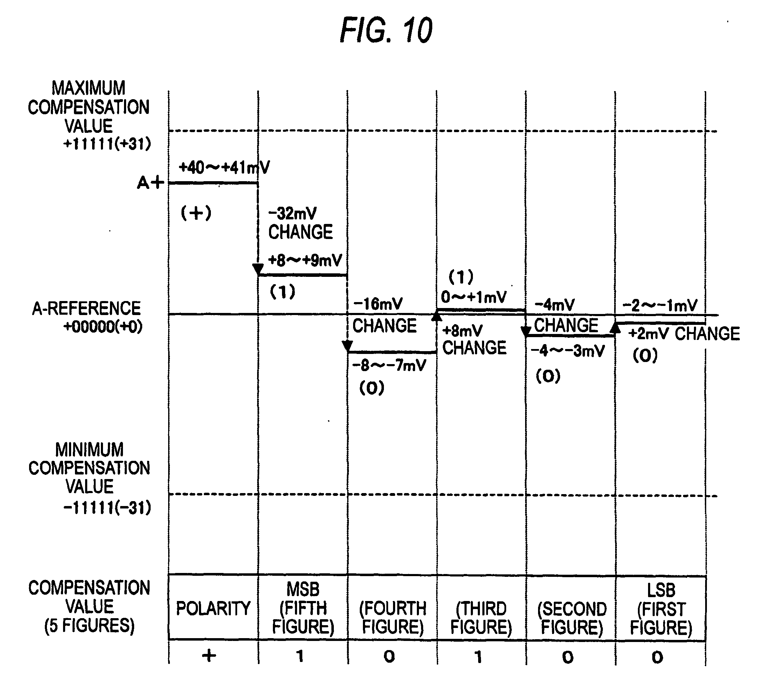

Particular procedures of calculating the compensation value by using the binary search method are shown in FIG.10. As explained in the above, assume that 1 LSB of the offset compensation D/A converter 32 is 1 mV. In the case of the differential output type D/A converter, a correction of -2 mV is applied in total between A+, A- in response to the compensation value "+1".

Supposed that the DC offset between the differential outputs is +40 mV to +41 mV between A+ and A-, and the comparator has no DC offset, and also the number of figures of the compensation value is set to five. Since the output of the comparator 50 is input into the logic circuit 15 as it is in the first input mode, the first output of the comparator 50 becomes +1 because A+ is larger than A-. This indicates that the polarity of the compensation value is "plus", and "+10000" is output from the logic circuit 15 to the register 26.

When the output OA+ and the output OA- of the main D/A converter 30 are respectively corrected by -16 mV and +16 mV by the offset compensation D/A converter 32 and the signal synthesizing portions 34 and 36, a voltage difference between A+ and A- becomes +8 mV to +9 mV. The output of the comparator 50 is still kept at +1. Therefore, the fifth figure of the compensation value becomes "1", and "+11000" is output from the logic circuit 15 to the register 26.

When the output OA+ and the output OA- of the main D/A converter 30 are respectively corrected by -8 mV and +8 mV by the offset compensation D/A converter 32 and the signal synthesizing portions 34 and 36, a voltage difference between A+ and A- becomes -8 mV to -7 mV. In this case, since the output of the comparator 50 becomes - 1, the fourth figure of the compensation value becomes "0" and "+10100" is output from the logic circuit 15 to the register 26.

When the output OA+ and the output OA- of the main D/A converter 30 are respectively corrected by +4 mV and - 4 mV by the offset compensation D/A converter 32 and the signal synthesizing portions 34 and 36, a voltage difference between A+ and A- becomes 0 mV to +1 mV. In this case, since the output of the comparator 50 becomes +1, the third figure of the compensation value becomes "1", and "+10110"is output from the logic circuit 15 to the register 26.

When the output OA+ and the output OA- of the main D/A converter 30 are respectively corrected by -2 mV and +2 mV by the offset compensation D/A converter 32 and the signal synthesizing portions 34 and 36, a voltage difference between A+ and A- becomes -4 mV to -3 mV. In this case, since the output of the comparator 50 becomes - 1, the second figure of the compensation value becomes "0", and "+10101" is output from the logic circuit 15 to the register 26.

When the output OA+ and the output OA- of the main D/A converter 30 are respectively corrected by +1 mV and - 1 mV by the offset compensation D/A converter 32 and the signal synthesizing portions 34 and 36, a voltage difference between A+ and A- becomes -2 mV to -1 mV. In this case, since the output of the comparator 50 becomes - 1, the first figure of the compensation value becomes "0". That is, the first compensation value becomes "+10100".

If the figure of LSB of the first compensation value calculated by the binary search method is "0", the DC offset compensation precision of the D/A converter 30 is 0 mV to -2 mV". Therefore, the DC offset compensation precision of the D/A converter 30 becomes "± 1 mV" by adding "+1/2" to the first compensation value.

Also, if the figure of LSB of the first compensation value is "1", the DC offset compensation precision of the D/A converter 30 is "0 mV to +2 mV". Therefore, the DC offset compensation precision of the D/A converter 30 becomes "± 1 mV" by adding "-1/2" to the first compensation value.

Therefore, the case where the figure of LSB of the first compensation value calculated by the binary search method is "0" and the figure of LSB of the first compensation value is "1" are considered together, the DC offset compensation precision of the D/A converter 30 can be improved from "4 mV error at maximum" to "2 mV error at maximum" by performing a correction of "+1/2" or "-1/2" to the first compensation value, as described above.

Also, in the successive approximation method shown in FIG.10, etc., the measurement must be executed twenty two times. If the binary search method is employed, the compensation value is decided by executing the measurement six times from MSB (Most Significant Bit) to LSB and therefore a measuring time can be shortened.

In the second input mode, the second compensation value can also be calculated by the similar procedures. Also, procedures except the procedures of calculating the first and second compensation values are totally identical to those in the first embodiment.

### (Fifth Embodiment)

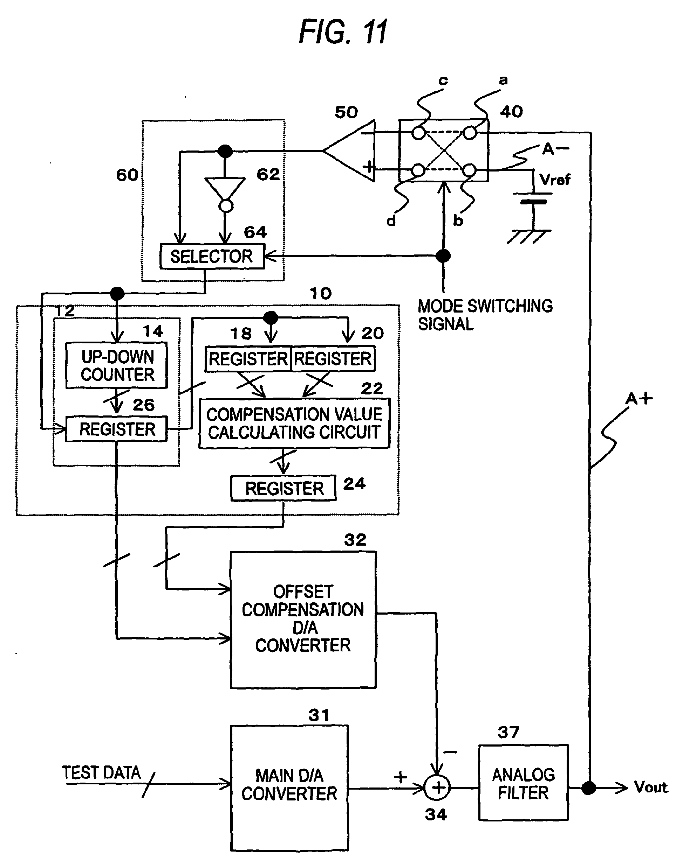

FIG.11 shows an example of a single output type D/A converter with the offset compensation function 31. One input (A+) of the input changing switch 40 is an output signal of the D/A converter 31, and the other input (A-) is a reference voltage (equivalent to an output voltage of the ideal D/A converter). Remaining configurations are identical to those mentioned above. In FIG.11, the same reference numerals and signs are affixed to the same portions as those in the above example.

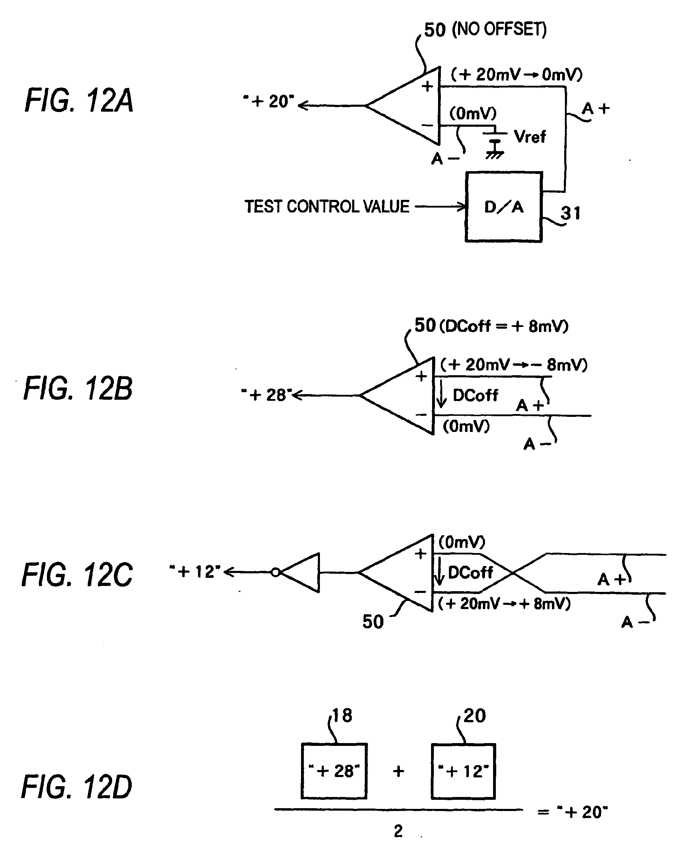

Distinguishing operations are shown in FIGs. 12A to 12D. These operations are similar in principle to the operations explained with reference to FIGs.5A to 5G. Assume that the minimum resolution (LSB) of the offset compensation D/A converter 32 is also set to 1 mV herein. In the case of the single output type D/A converter 31, a correction of -1 mV is applied to A+ only in response to the compensation value "+1". That is, the compensation value of the single output type D/A converting device is twice that of the differential output type D/A converting device.

That is, FIG.12A shows the compensation value of the DC offset of the D/A converter 31 when no DC offset exists in the comparator 50. FIG.12B shows the compensation value of the DC offset (corresponding to the first compensation value) of the D/A converter 31 when the DC offset exists in the comparator 50 before the inputs are switched. FIG.12C shows the compensation value of the DC offset (corresponding to the second compensation value) of the D/A converter 31 when the DC offset exists in the comparator 50 after the inputs are switched. FIG.12D shows the event that the third compensation value obtained by averaging the first and second compensation values coincides with the compensation value in FIG.12A. In this case, the reference voltage used herein is not always set to the voltage equivalent to the output of the ideal D/A converter, and a constant voltage value may be used as the reference voltage.

Also, as explained in the first embodiment, in this fifth embodiment, it is possible similarly to employ the configuration in which the connection between the input terminal of the comparator 50 and the input changing switch 40 is reversed, and the configuration in which the first compensation value is calculated based on the inverted signal of the output signal of the comparator 50 in the first input mode and also the second compensation value is calculated based on the output signal of the comparator 50 in the second input mode.

Also, as explained in the second and third embodiments, in this fifth embodiment, it is possible similarly to employ the configuration in which, instead of the removal of the polarity inverting circuit 60 to selectively invert the polarity of the output signal of the comparator 50, the counting operation of the up-down counter 14 is reversely switched by the mode switching signal in the first input mode and the second input mode.

Also, instead of the removal of the polarity inverting circuit 60 for inverting selectively the polarity of the output signal of the comparator 50, the offset compensation D/A converter 32 may be replaced with an offset compensation D/A converter 33 with a controlling function, and then a signal of causing the signal synthesizing portion 34 to subtract the output voltage of the offset compensation D/A converter 33 from the output voltage of the D/A converter 30 may be switched into an output signal, which is equal in magnitude but opposite in polarity to the output signal in the first input mode, by the mode switching signal in the second input mode.

### (Sixth Embodiment)

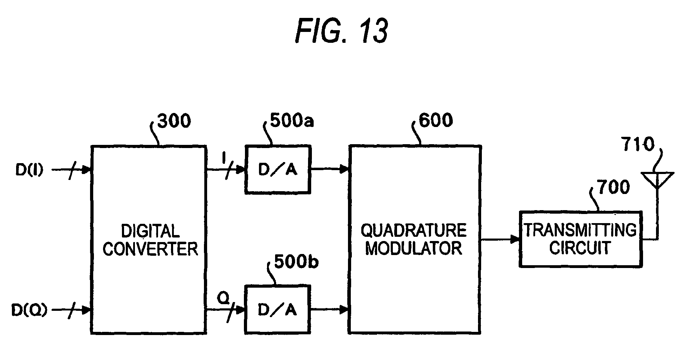

FIG.13 is a block diagram showing a schematic configuration of a digital radio transmitter that employs the D/A converting device with the offset compensation function of the present invention. As shown in FIG.13, this digital radio transmitter has a digital converter 300, D/A converting devices 500a, 500b corresponding to I, Q respectively (which are the D/A converting device with the offset compensation function of the present invention), a quadrature modulator 600, a transmitting circuit 700, and an antenna 710. The digital converter 300 is composed of a diffusion modulator, for example. Also, the quadrature modulator 600 is composed of a QPSK (Quad Phase Shift Keying) modulator, for example. The digital converter 300, the D/A converting devices 500a, 500b, the quadrature modulator 600, and the transmitting circuit 700 are integrated in one LSI respectively.

According to the sixth embodiment, since the DC offset is canceled, input/output characteristics of two D/A converting devices 500a, 500b coincide with each other and thus respective I, Q transmission signals coincide in phase with each other, which makes the precise transmission possible.

The D/A converting device with the offset compensation function according to the present invention can be employed not only for the communication application but also for the audio device, etc.

According to the D/A converting device with the offset compensation function and the method of compensating the offset of the D/A converting device, information of the voltage that is equal in magnitude but opposite in polarity to the DC offset contained in the comparator itself are generated indirectly by executing the switching of the inputs into the comparator, and then the DC offset of the comparator itself is canceled when the DC offset of the D/A converter is to be measured, which makes possible exact measurement of the DC offset of the D/A converter. Accordingly, the DC offset of the D/A converter can be removed substantially completely without the influence of the DC offset that exists in the comparator. In addition, the DC offset of the comparator is increased more and more as the miniaturization of the analog circuit is accelerated. As a result, the D/A converting device is very effective as a means for implementing the D/A converter from which the DC offset is eliminated substantially perfectly by the fine pattern processing.

## Claims

1. A D/A converting device with an offset compensation function for compensating a DC offset of a D/A converter, comprising:
a comparator (50) for detecting the DC offset of the D/A converter;
a changing switch (40) for selecting the inputs to the comparator based on a mode switching signal, wherein
in a first input mode first and second signals are input into first and second input terminals of the comparator (50) respectively,
in a second input mode the second and first signals are input into the first and second terminals of the comparator (50) respectively, and
at least one of the first and second signals is an output signal of the D/A converter; and
offset compensating means (10) for calculating a third compensation value from a first compensation value which is obtained based on an output signal of the comparator (50) in the first input mode and a second compensation value which is obtained based on an output signal of the comparator (50) in the second input mode; and
an offset compensation D/A converter (32) for correcting the output signal of the D/A converter based on the third compensation value;
**characterized in that**
said offset compensating means (10) determines the first and second compensation values by using the successive approximation method based on a binary search, and
said offset compensating means (10) adds 1/2 to the first and second compensation values when least significant bits of the first and second compensation values are 0, and subtract 1/2 from the first and second compensation values when the least significant bits of the first and second compensation values are 1.

## Patentansprüche

1. Digital-Analog-Umwandlungsvorrichtung mit einer Offset-Kompensationsfunktion zum Kompensieren eines Gleichstrom-Offsets eines Digital-Analog-Wandlers, die umfasst:
einen Komparator (50) zum Erfassen des Gleichstrom-Offsets des Digital-Analog-Wandlers;
einen Wechselschalter (40) zum Auswählen der Eingänge des Komparators auf Basis eines Modus-Umschaltsignals, wobei
in einem ersten Eingangsmodus ein erstes und ein zweites Signal in einen ersten bzw. einen zweiten Eingangsanschluss des Komparators (50) eingegeben werden,
in einem zweiten Eingangsmodus das zweite und das erste Signal in den ersten bzw. den zweiten Anschluss des Komparators (50) eingegeben werden, und
wenigstens das erste oder das zweite Signal ein Ausgangssignal des Digital-Analog-Wandlers ist; und
eine Offset-Kompensationseinrichtung (10) zum Berechnen eines dritten Kompensationswertes aus einem ersten Kompensationswert, der auf Basis eines Ausgangssignals des Komparators (50) in dem ersten Eingangsmodus ermittelt wird, sowie eines zweiten Kompensationswertes, der auf Basis eines Ausgangssignals des Komparators (50) in dem zweiten Eingangsmodus ermittelt wird, und
einen Offset-Kompensations-Digital-Ana log-Wandler (32) zum Korrigieren des Ausgangssignals des Digital-Analog-Wandlers auf Basis des dritten Kompensationswertes;
**dadurch gekennzeichnet, dass**
die Offset-Kompensationseinrichtung (10) den ersten und den zweiten Kompensationswert unter Verwendung des Verfahrens schrittweiser Näherung auf Basis einer binären Suche bestimmt, und
die Offset-Kompensationseinrichtung (10) zu dem ersten und dem zweiten Kompensationswert 1/2 addiert, wenn niedrigstwertige Bits des ersten und des zweiten Kompensationswertes 0 sind, und von dem ersten sowie dem zweiten Kompensationswert 1/2 subtrahiert, wenn niedrigstwertige Bits des ersten und des zweiten Kompensationswertes 1 sind.

## Revendications

1. Dispositif de conversion de numérique en analogique (N/A) présentant une fonction de compensation de décalage destinée à compenser un décalage de niveau continu d'un convertisseur de numérique en analogique (N/A), comprenant :
un comparateur (50) destiné à détecter le décalage de niveau continu du convertisseur N/A,
un commutateur de basculement (40) destiné à sélectionner les entrées vers le comparateur sur la base d'un signal de basculement de mode où
dans un premier mode d'entrée, des premier et second signaux sont appliqués en entrée vers des première et seconde bornes d'entrée du comparateur (50), respectivement,
dans un second mode d'entrée, les second et premier signaux sont appliqués en entrée vers les première et seconde bornes du comparateur (50) respectivement, et
au moins l'un des premier et second signaux est un signal de sortie du convertisseur N/A, et
un moyen de compensation de décalage (10) destiné à calculer une troisième valeur de compensation à partir d'une première valeur de compensation qui est obtenue sur la base d'un signal de sortie du comparateur (50) dans le premier mode d'entrée et d'une seconde valeur de compensation qui est obtenue sur la base d'un signal de sortie du comparateur (50) dans le second mode d'entrée, et
un convertisseur de numérique en analogique N/A de compensation en décalage (32) destiné à corriger le signal de sortie du convertisseur N/A sur la base de la troisième valeur de compensation,
**caractérisé en ce que**
ledit moyen de compensation de décalage (10) détermine les première et seconde valeurs de compensation en utilisant le procédé d'approximations successives fondé sur une recherche dichotomique, et
ledit moyen de compensation de décalage (10) ajoute 1/2 aux première et seconde valeurs de compensation lorsque les bits les moins significatifs des première et seconde valeurs de compensation valent 0, et soustrait 1/2 des première et seconde valeurs de compensation lorsque les bits les moins significatifs des première et seconde valeurs de compensation valent 1.
